# EUROPEAN PATENT SPECIFICATION

(11) **EP 4 039 845 B1**
(45) Date of publication and mention of the grant of the patent: **29.11.2023**
(21) Application number: 20871764.5
(22) Date of filing: 03.09.2020
(51) Int. Cl.: C23C 14/02, C23C 14/06, C23C 14/30, C23C 14/58, C23C 16/44, C23C 28/04

(54) **CORROSION-RESISTANT MEMBER**
KORROSIONSBESTÄNDIGES ELEMENT
ÉLÉMENT RÉSISTANT À LA CORROSION

(30) Priority: 04.10.2019 JP 2019184106
(43) Date of publication of application: 10.08.2022
(73) Proprietor: Resonac Corporation, Tokyo (JP)
(72) Inventor: MIYAISHI, So, Tokyo 105-8518 (JP); OKUBO, Masahiro, Tokyo 105-8518 (JP); YOSHIMURA, Masayuki, Tokyo 105-8518 (JP); SAKANE, Wataru, Tokyo 105-8518 (JP); TANAKA, Teppei, Tokyo 105-8518 (JP); NAKAMURA, Saeko, Tokyo 105-8518 (JP); YAMAKI, Saori, Tokyo 105-8518 (JP)
(74) Representative: Strehl Schübel-Hopf & Partner
(86) International application number: PCT/JP2020/033461
(87) International publication number: WO 2021/065327

(56) References cited:
- EP-A2- 1 026 281
- JP-A- 2000 219 574
- JP-A- 2001 240 482
- JP-A- 2004 319 803
- JP-A- 2009 117 373
- JP-A- 2009 256 800
- US-A1- 2003 148 035

## Description

### Technical Field

The present invention relates to a corrosion-resistant member.

### Background Art

In a semiconductor manufacturing process, highly corrosive gases, such as chlorine gas and fluorine gas, are sometimes used, and therefore members constituting a semiconductor manufacturing apparatus are required to have corrosion resistance. Examples of the members constituting the semiconductor manufacturing apparatus include chambers, pipes, gas storage devices, valves, susceptors, shower heads, and the like.

PTL 1 discloses a member, such as a shower head, used in a semiconductor manufacturing process. This member has an aluminum surface coated with a corrosion-resistant coating composed of at least one of aluminum fluoride and magnesium fluoride.

PTL 2 discloses a vacuum chamber member obtained by forming a corrosion-resistant coating on the surface of a base material. The surface side of the corrosion-resistant coating is a layer mainly containing aluminum oxide or a layer mainly containing aluminum oxide and aluminum fluoride. The base material side of the corrosion-resistant coating is a layer mainly containing magnesium fluoride or a layer mainly containing magnesium fluoride and aluminum oxide.

PTL 3 discloses a corrosion-resistant member comprising a metal base coated with an aluminum or magnesium fluoride layer.

### Citation List

### Patent Literatures

PTL 1: JP 2005-533368 A (Translation of PCT Application)
PTL 2: JP 11-61410 A PTL 3: EP 1026281 A2

### Summary of Invention

### Technical Problem

However, the members disclosed in PTLS 1, 2 and 3 have had a problem that the corrosion-resistant coatings are likely to peel off from the base material due to a thermal history.

It is an object of the present invention to provide a corrosion-resistant member in which a corrosion-resistant coating is difficult to peel off from a base material even when subjected to a thermal history.

### Solution to Problem

In order to solve the above-described problem, one aspect of the present invention is a corrosion-resistant member as disclosed in appended claims 1-4.

### Advantageous Effects of Invention

In the corrosion-resistant member according to the present invention, the corrosion-resistant coating is difficult to peel off from the base material even when subjected to a thermal history.

### Brief Description of Drawings

FIG. 1 is a cross-sectional view illustrating the configuration of a corrosion-resistant member according to one embodiment of the present invention;
FIG. 2 is an electron beam diffraction image obtained by irradiating a first crystalline layer possessed by the corrosion-resistant member of FIG. 1 with electron beams;
FIG. 3 is an electron beam diffraction image obtained by irradiating an amorphous layer possessed by the corrosion-resistant member of FIG. 1 with electron beams; and
FIG. 4 is an electron beam diffraction image obtained by irradiating a second crystalline layer possessed by the corrosion-resistant member of FIG. 1 with electron beams.

### Description of Embodiments

One embodiment of the present invention will now be described below.

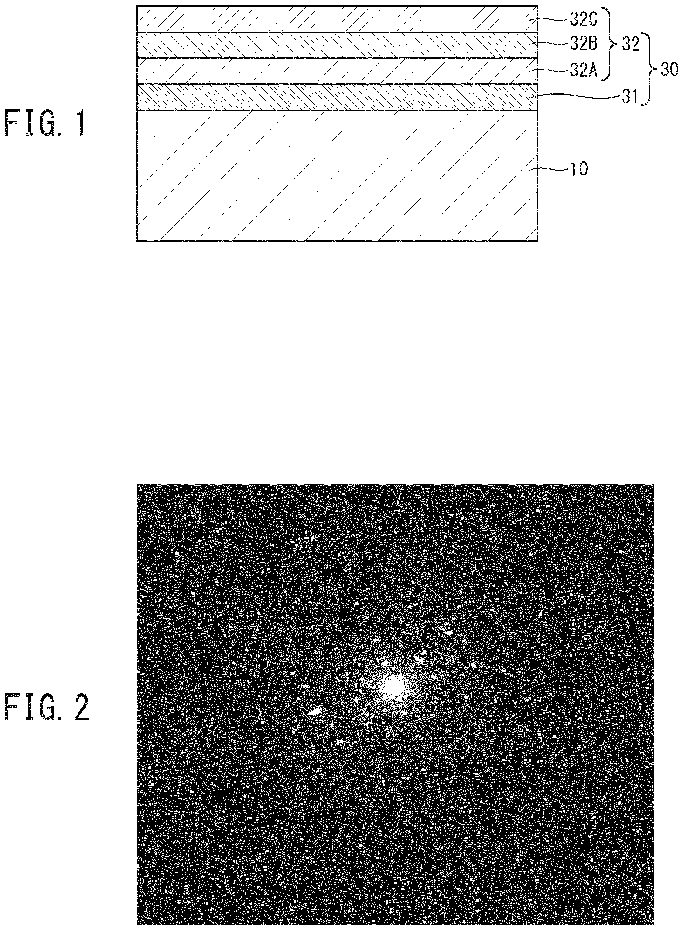

As illustrated in FIG. 1, a corrosion-resistant member according to this embodiment includes a metal base material 10 and a corrosion-resistant coating 30 formed on the surface of the base material 10. The corrosion-resistant coating 30 is a stack of a magnesium fluoride layer 31 containing magnesium fluoride (MgF₂) and an aluminum fluoride layer 32 containing aluminum fluoride (AlF₃) in order from the base material 10 side.

The aluminum fluoride layer 32 is a stack of a first crystalline layer 32A containing crystalline aluminum fluoride, an amorphous layer 32B containing amorphous aluminum fluoride, and a second crystalline layer 32C containing crystalline aluminum fluoride in order from the magnesium fluoride layer 31 side.

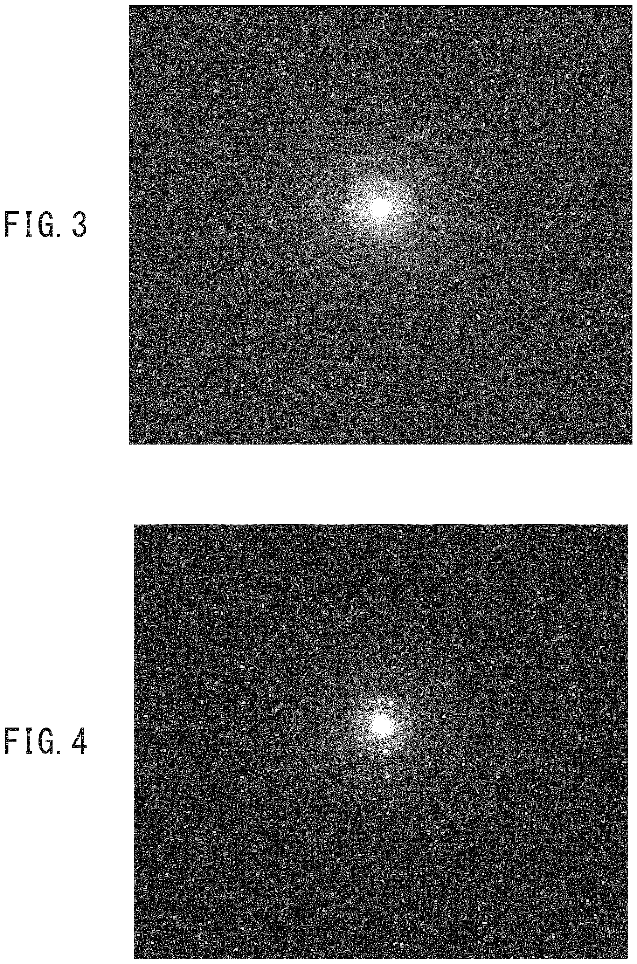

As illustrated in FIGS. 2, 4, the first crystalline layer 32A and the second crystalline layer 32C are layers in which diffraction spots are observed in electron beam diffraction images obtained by electron beam irradiation. As illustrated in FIG. 3, the amorphous layer 32B is a layer in which a halo pattern is observed in an electron beam diffraction image obtained by electron beam irradiation and is preferably a layer in which only a halo pattern is observed.

In the first crystalline layer 32A and the second crystalline layer 32C, the contained aluminum fluoride may be at least partially crystalline and need not be entirely crystalline. The aluminum fluoride of the first crystalline layer 32A and the second crystalline layer 32C may be at least one selected from aluminum fluoride (AlF₃), aluminum fluoride hydrate (AlF₃·nH₂O), aluminum fluoride containing a part of a hydroxyl group (AlF₃₋ₓ(OH)ₓ), aluminum fluoride hydrate containing a part of a hydroxyl group (AlF₃₋ₓ(OH)ₓ·nH₂O), aluminum fluoride containing a part of oxygen (AlF₃₍₁₋ₓ₎O_{3/2X}), and aluminum fluoride hydrate containing a part of oxygen (AlF₃₍₁₋ₓ₎O_{3/2X}·nH₂O). The amorphous aluminum fluoride contained in the amorphous layer 32B may be at least one selected from aluminum fluoride (AlF₃), aluminum fluoride hydrate (AlF₃·nH₂O), aluminum fluoride containing a part of a hydroxyl group (AlF₃₋ₓ(OH)ₓ), aluminum fluoride hydrate containing a part of a hydroxyl group (AlF₃₋ₓ(OH)ₓ·nH₂O), aluminum fluoride containing a part of oxygen (AlF₃₍₁₋ₓ₎O_{3/2X}), and aluminum fluoride hydrate containing a part of oxygen (AlF₃₍₁₋ₓ₎O_{3/2x}-nH₂O).

The corrosion-resistant member according to this embodiment includes the corrosion-resistant coating 30, and therefore has excellent corrosion resistance even in highly corrosive gas or plasma. The magnesium fluoride layer 31 is interposed between the aluminum fluoride layer 32 and the base material 10, and therefore the adhesion between the aluminum fluoride layer 32 and the base material 10 is high. Further, the aluminum fluoride layer 32 has a sandwich structure in which the amorphous layer 32B is sandwiched between the first crystalline layer 32A and the second crystalline layer 32C, and therefore, even when subjected to a thermal history, the corrosion-resistant coating 30 is difficult to peel off from the base material 10 and cracking is difficult to occur. For example, even when subjected to a thermal history in which the temperature is repeatedly raised and lowered, peeling or cracking is difficult to occur in the corrosion-resistant coating 30. As a result, the corrosion-resistant member according to this embodiment has excellent corrosion resistance even when subjected to a thermal history and the generation of particles resulting from the peeling of the corrosion-resistant coating 30 is suppressed.

Such a corrosion-resistant member according to this embodiment is suitable as a member requiring corrosion resistance and heat resistance and suitable as a member constituting, for example, a semiconductor manufacturing apparatus (particularly, a film deposition apparatus using a chemical vapor deposition method). As a specific example, the corrosion-resistant member is suitable as a susceptor and a shower head of a film deposition apparatus forming a thin film on a wafer in a state where plasma is generated. The use of the corrosion-resistant member according to this embodiment as the member constituting the semiconductor manufacturing apparatus suppresses the generation of particles, so that a semiconductor can be manufactured with a high yield.

The corrosion-resistant member according to this embodiment can be manufactured by, for example, forming the magnesium fluoride layer 31 on the surface of the base material 10, and further forming, on the magnesium fluoride layer 31, the first crystalline layer 32A, the amorphous layer 32B, and the second crystalline layer 32C in this order to form the aluminum fluoride layer 32.

The magnesium fluoride layer 31 can be formed by, for example, a method, such as vacuum deposition or sputtering. The first crystalline layer 32A and the second crystalline layer 32C of the aluminum fluoride layer 32 can also be formed by a method, such as vacuum deposition or sputtering. Particularly by controlling a target on which an aluminum fluoride layer is formed to a high temperature, the crystallinity of the aluminum fluoride layer can be enhanced. The amorphous layer 32B can be formed by, for example, a vapor deposition method (Physical Vapor Deposition (PVD), Chemical Vapor Deposition (CVD), or the like). Particularly by controlling a target on which an aluminum fluoride layer is formed to a low temperature, the crystallinity of the aluminum fluoride layer can be suppressed.

Hereinafter, the corrosion-resistant member according to this embodiment is described in more detail.

The metal constituting the base material 10 is not particularly limited and may be a simple metal (containing inevitable impurities) or an alloy. For example, aluminum or an aluminum alloy may be acceptable.

The thickness of the magnesium fluoride layer 31 is preferably 100 nm or more and 1000 nm or less. When the thickness of the magnesium fluoride layer 31 is within the range above, the adhesion between the aluminum fluoride layer 32 and the base material 10 is further enhanced.

The thickness of the aluminum fluoride layer 32, i.e., the total thickness of the first crystalline layer 32A, the second crystalline layer 32C, and the amorphous layer 32B, is preferably 200 nm or more and 50000 nm or less. When the thickness of the aluminum fluoride layer 32 is within the range above, the difficulty of peeling of the corrosion-resistant coating 30 when subjected to a thermal history is further enhanced.

Examples of a method for measuring the thickness of the magnesium fluoride layer 31 and the aluminum fluoride layer 32 include, but not particularly limited to, a transmission electron microscope (TEM), a scanning transmission electron microscope (STEM), a scanning electron microscope (SEM), and the like, for example. The thickness of the first crystalline layer 32A, amorphous layer 32B, and the second crystalline layer 32C can be measured by similar methods.

Elements, such as magnesium and aluminum, present in the magnesium fluoride layer 31 and the aluminum fluoride layer 32 can be quantified by, for example, energy dispersive X-ray spectroscopy (EDS).

The presence of the crystalline or amorphous aluminum fluoride in the first crystalline layer 32A, the amorphous layer 32B, and the second crystalline layer 32C can be analyzed by an electron beam diffraction method (electron beam diffraction image obtained by electron beam irradiation) . The conditions of the electron beam diffraction method in the present invention are as follows. More specifically, the electron beam diffraction method is a method for obtaining an electron beam diffraction image by the TEM, the method in which a sample processed to have a thickness of 40 nm or more and 100 nm or less with an ion slicer is used and the beam diameter of electron beams is set to 10 nm or more and 20 nm or less.

### EXAMPLES

Hereinafter, the present invention is more specifically described by illustrating Example and Comparative Examples.

### [Example 1]

A base material was first subjected to pre-treatment, and then subjected to vacuum deposition, thereby forming a magnesium fluoride layer on the surface of the base material. Thereafter, a first crystalline layer, an amorphous layer, and a second crystalline layer were formed on the magnesium fluoride layer in this order to form an aluminum fluoride layer to give a corrosion-resistant member. The first crystalline layer and the second crystalline layer were formed by thermal vapor deposition. The amorphous layer was formed by normal temperature vapor deposition.

Metal constituting the base material is an aluminum alloy A5052 containing 2.55% by mass of magnesium. The pre-treatment to the base material was performed as follows. First, a degreasing liquid was obtained by dissolving 70 g of S-CLEAN AL-13 (manufactured by SASAKI CHEMICAL CO., LTD.) in 1 L of water and setting the temperature to 50°C. Then, the base material was immersed in the degreasing liquid for 10 minutes for degreasing, followed by washing with pure water. Next, an etchant was obtained by heating 500 g of S-CLEAN AL-5000 (manufactured by SASAKI CHEMICAL CO., LTD.) to 70°C. Then, the degreased base material was immersed in the etchant for 1 minute for etching, followed by washing with pure water. Thereafter, a smut removing liquid was obtained by dissolving 200 g of Smut Clean (Raiki K.K.) in 400 g of water and setting the temperature to 25°C. Then, the etched base material was immersed in the smut removing liquid for 30 seconds to remove smut, followed by washing with pure water. Then, the base material from which smut was removed was vacuum-dried to complete the pre-treatment.

The conditions of the vacuum deposition in forming the magnesium fluoride layer are as follows. First, the base material subjected to the pre-treatment was installed in a vacuum chamber, and then the inside of the vacuum chamber was evacuated until the degree of vacuum reached 2 × 10⁻⁴ Pa. Thereafter, the base material subjected to the pre-treatment was heated to 380°C. A magnesium fluoride sintered body material was used as a vapor deposition material, the sintered body material was irradiated with electron beams, and then a shutter was opened, so that a magnesium fluoride layer having a thickness of about 235 nm was formed on the base material subjected to the pre-treatment. The electron beam input power at this time was about 40 mA at an acceleration voltage of 5 kV and the degree of vacuum in the vapor deposition was set to 5 × 10⁻⁴ Pa.

The conditions of the vapor deposition in forming the first crystalline layer are as follows. First, the base material on which the magnesium fluoride layer was formed was installed in a vacuum chamber, and then the inside of the vacuum chamber was evacuated until the degree of vacuum reached 2 × 10⁻⁴ Pa. Thereafter, the base material on which the magnesium fluoride layer was formed was heated to 400°C. An aluminum fluoride sintered body material was used as a vapor deposition material, the sintered body material was irradiated with electron beams, and then a shutter was opened, so that an aluminum fluoride layer having a thickness of 236 nm was formed on the magnesium fluoride layer of the base material heated to 400°C. The electron beam input power at this time was about 40 mA at an acceleration voltage of 5 kV and the degree of vacuum in the vapor deposition was set to 5 × 10⁻⁴ Pa.

The conditions of the vapor deposition in forming the amorphous layer are as follows. First, the base material on which the first crystalline layer was formed was installed in a vacuum chamber, and then the inside of the vacuum chamber was evacuated until the degree of vacuum reached 2 × 10⁻⁴ Pa and the temperature was kept at normal temperature. An aluminum fluoride sintered body material was used as a vapor deposition material, the sintered body material was irradiated with electron beams, and then a shutter was opened, so that an aluminum fluoride layer having a thickness of about 451 nm was formed on the first crystalline layer of the base material kept at normal temperature. The electron beam input power at this time was about 40 mA at an acceleration voltage of 5 kV and the degree of vacuum in the vapor deposition was set to 5 × 10⁻⁴ Pa.

The conditions of the vapor deposition in forming the second crystalline layer are similar to those in the case of the first crystalline layer. The base material having the amorphous layer formed on the first crystalline layer was heated to 400°C, and then an aluminum fluoride layer having a thickness of about 249 nm was formed as the second crystalline layer on the amorphous layer of the base material heated to 400°C.

After forming the first crystalline layer, the amorphous layer, and the second crystalline layer, the base material was heated to 350°C in a 20% fluorine gas (the remaining 80% was nitrogen gas) atmosphere to compensate the deficiency of fluorine atoms generated during the vapor deposition.

Elements, such as magnesium and aluminum, present in the formed magnesium fluoride layer and the formed aluminum fluoride layer were analyzed by the EDS. In detail, a sample processed to a thickness of 40 nm or more and 100 nm or less with an ion slicer was subjected to a point analysis of each layer at an acceleration voltage of 200 V to analyze the elements, such as magnesium and aluminum.

The presence of crystalline or amorphous aluminum fluoride in the formed first crystalline layer, the formed amorphous layer, and the formed second crystalline layer was confirmed by the electron beam diffraction method. In detail, a sample processed to a thickness of 40 nm or more and 100 nm or less with an ion slicer was irradiated with electron beams having a beam diameter of 10 nm or more and 20 nm or less, and an electron beam diffraction image was obtained by the TEM. The electron beam diffraction images of the first crystalline layer, the amorphous layer, and the second crystalline layer are illustrated in FIG. 2, FIG. 3, and FIG. 4, respectively.

The obtained corrosion-resistant member of Example 1 was subjected to a heating test, thereby evaluating the state of peeling of the corrosion-resistant coating. The conditions of the heating test are as follows: a step of keeping the corrosion-resistant member at 300°C for 300 min in a nitrogen gas atmosphere, and then naturally cooling the corrosion-resistant member to an ambient temperature was set as one cycle, and 10 cycles were performed.

After the heating test was completed, the corrosion-resistant coating of the corrosion-resistant member was observed with a scanning electron microscope, thereby evaluating the degree of peeling. The results are shown in Table 1. In Table 1, a case where the area of a peeled part of the corrosion-resistant coating was less than 1% of the area of the corrosion-resistant coating is indicated by A, a case where the area was 1% or more and less than 10% is indicated by B, a case where the area was 10% or more and less than 50% is indicated by C, and a case where the area was 50% or more is indicated by D.

The obtained corrosion-resistant member of Example 1 was subjected to a corrosion test, thereby evaluating the state of peeling of the corrosion-resistant coating. The corrosion test involved performing heat treatment under a fluorine gas (F₂)-containing inert gas atmosphere. The conditions of the corrosion test are as follows: the concentration of the fluorine gas in the inert gas atmosphere is 1% by volume, the heat treatment temperature is 300°C, and the heat treatment time is 300 min.

After the corrosion test was completed, the surface of the corrosion-resistant coating of the corrosion-resistant member was observed with a scanning electron microscope, thereby evaluating the degree of peeling. The results are shown in Table 1. In Table 1, a case where the area of a peeled part of the corrosion-resistant coating was less than 1% of the area of the corrosion-resistant coating is indicated by A, a case where the area was 1% or more and less than 10% is indicated by B, a case where the area was 10% or more and less than 50% is indicated by C, and a case where the area was 50% or more is indicated by D. The numerical values each in Table 1 indicate the thickness of each layer, and "-" indicates that the layer is not formed.

**[Table 1]**

| | Magnesium fluoride layer (nm) | Aluminum fluoride layer (nm) | | | State of peeling of corrosion-resistant coating | |
|---|---|---|---|---|---|---|
| | | First crystalline layer | Amorphous layer | Second crystalline layer | After heating test | After corrosion test |
| Ex. 1 | 235 | 236 | 451 | 249 | A | A |
| Comp. Ex. 1 | 240 | 246 | 443 | - | A | D |
| Comp. Ex. 2 | 243 | 230 | - | 252 | C | A |
| Comp. Ex. 3 | 239 | - | 461 | 267 | D | A |
| Comp. Ex. 4 | - | 239 | 421 | 254 | D | A |
| Comp. Ex. 5 | 242 | 231 | - | - | C | A |
| Comp. Ex. 6 | 239 | - | - | - | A | C |

### [Comparative Example 1]

A corrosion-resistant member was manufactured and evaluated in the same manner as in Example 1, except that only the first crystalline layer and the amorphous layer were formed as the aluminum fluoride layers on the magnesium fluoride layer and the second crystalline layer was not formed. The results are shown in Table 1.

### [Comparative Example 2]

A corrosion-resistant member was manufactured and evaluated in the same manner as in Example 1, except that only the first crystalline layer and the second crystalline layer were formed as the aluminum fluoride layers on the magnesium fluoride layer and the amorphous layer was not formed. The results are shown in Table 1.

### [Comparative Example 3]

A corrosion-resistant member was manufactured and evaluated in the same manner as in Example 1, except that only the amorphous layer and the second crystalline layer were formed as the aluminum fluoride layers on the magnesium fluoride layer and the first crystalline layer was not formed. The results are shown in Table 1.

### [Comparative Example 4]

A corrosion-resistant member was manufactured and evaluated in the same manner as in Example 1, except that the magnesium fluoride layer was not formed on the base material. The results are shown in Table 1.

### [Comparative Example 5]

A corrosion-resistant member was manufactured and evaluated in the same manner as in Example 1, except that only the first crystalline layer was formed as the aluminum fluoride layer on the magnesium fluoride layer and the amorphous layer and the second crystalline layer were not formed. The results are shown in Table 1.

### [Comparative Example 6]

A corrosion-resistant member was manufactured and evaluated in the same manner as in Example 1, except that the aluminum fluoride layers were not formed on the magnesium fluoride layer. The results are shown in Table 1.

As is understood from Table 1, in Example 1, the peeling of the corrosion-resistant coating hardly occurred even when subjected to a thermal history by the heating test. Further, even when corroded by the corrosion test, the peeling of the corrosion-resistant coating hardly occurred.

In contrast thereto, in Comparative Examples 1, 6 not having the crystalline aluminum fluoride layer on the surface, the peeling of the corrosion-resistant coating by the corrosion test occurred. It is found that, particularly in Comparative Example 1 having the amorphous layer on the outermost surface, the corrosion is likely to occur by fluorine gas. It is found that Comparative Example 6 having the magnesium fluoride layer as the outermost surface had the corrosion resistance lower than that of Example 1 having the crystalline aluminum fluoride layer as the outermost surface.

In Comparative Example 4 having the aluminum fluoride layer directly formed on the metal base material without interposing the magnesium fluoride layer therebetween, the peeling off from the interface occurred when the temperature was repeatedly raised and lowered.

In Comparative Example 2 not having the amorphous layer between the first crystal layer and the second crystal layer, cracking occurred in the stacking direction of the aluminum fluoride layers when the temperature was repeatedly raised and lowered, resulting in peeling. From this result, it is expected that the amorphous layer contributes to reducing a stress caused by temperature changes.

In Comparative Example 5 having only the first crystal layer on the magnesium fluoride layer, there was tendency that cracking due to repeated temperature rise and fall was likely to occur as compared with Example 1, and the peeling occurred with the cracking as the starting point. Also from this result, it is expected that the amorphous layer contributes to reducing the stress caused by temperature changes.

In Comparative Example 3 having the amorphous layer on the magnesium fluoride layer, the peeling was likely to occur at the interface due to repeated temperature rise and fall.

### Reference Signs List

- 10: base material
- 30: corrosion-resistant coating
- 31: magnesium fluoride layer
- 32: aluminum fluoride layer
- 32A: first crystalline layer
- 32B: amorphous layer
- 32C: second crystalline layer

## Claims

1. A corrosion-resistant member comprising:
a metal base material; and
a corrosion-resistant coating formed on a surface of the base material, wherein
the corrosion-resistant coating is a stack of a magnesium fluoride layer containing magnesium fluoride and an aluminum fluoride layer containing aluminum fluoride in order from a side of the base material,
the aluminum fluoride layer is a stack of a first crystalline layer containing crystalline aluminum fluoride, an amorphous layer containing amorphous aluminum fluoride, and a second crystalline layer containing crystalline aluminum fluoride in order from a side of the magnesium fluoride layer,
the first crystalline layer and the second crystalline layer are layers in which diffraction spots are observed in an electron beam diffraction image obtained by electron beam irradiation, and
the amorphous layer is a layer in which a halo pattern is observed in an electron beam diffraction image obtained by electron beam irradiation.

2. The corrosion-resistant member according to claim 1, wherein the metal base material is made of aluminum or an aluminum alloy.

3. The corrosion-resistant member according to claim 1 or 2, wherein a thickness of the magnesium fluoride layer is 100 nm or more and 1000 nm or less.

4. The corrosion-resistant member according to any one of claims 1 to 3, wherein a total thickness of the aluminum fluoride layer is 200 nm or more and 50000 nm or less.

## Patentansprüche

1. Korrosionsbeständiges Bauteil das Folgendes umfasst:
ein metallisches Grundmaterial und
eine auf einer Oberfläche des Basismaterials ausgebildete korrosionsbeständige Beschichtung, wobei
die korrosionsbeständige Beschichtung ein Stapel aus einer Magnesiumfluorid enthaltenden Magnesiumfluoridschicht und einer Aluminiumfluorid enthaltenden Aluminiumfluoridschicht in der Reihenfolge von einer Seite des Grundmaterials aus ist,
die Aluminiumfluoridschicht ein Stapel aus einer ersten kristallinen Schicht, die kristallines Aluminiumfluorid enthält, einer amorphen Schicht, die amorphes Aluminiumfluorid enthält, und einer zweiten kristallinen Schicht, die kristallines Aluminiumfluorid enthält, in der Reihenfolge von einer Seite der Magnesiumfluoridschicht aus ist,
die erste kristalline Schicht und die zweite kristalline Schicht Schichten sind, in denen Beugungsflecken in einem durch Elektronenstrahlbestrahlung erhaltenen Elektronenbeugungsbild beobachtet werden, und
die amorphe Schicht eine Schicht ist, in der ein Halo-Muster in einem durch Elektronenstrahlbestrahlung erhaltenen Elektronenstrahlbeugungsbild beobachtet wird.

2. Korrosionsbeständiges Bauteil nach Anspruch 1, wobei das metallische Grundmaterial aus Aluminium oder einer Aluminiumlegierung hergestellt ist.

3. Korrosionsbeständiges Bauteil nach Anspruch 1 oder 2, wobei die Dicke der Magnesiumfluoridschicht 100 nm oder mehr und 1000 nm oder weniger beträgt.

4. Korrosionsbeständiges Bauteil nach einem der Ansprüche 1 bis 3, wobei die Gesamtdicke der Aluminiumfluoridschicht 200 nm oder mehr und 50000 nm oder weniger beträgt.

## Revendications

1. Élément résistant à la corrosion comprenant :
un matériau de base métallique ; et
un revêtement résistant à la corrosion formé sur une surface du matériau de base, dans lequel
le revêtement résistant à la corrosion est un empilement d'une couche de fluorure de magnésium contenant du fluorure de magnésium et d'une couche de fluorure d'aluminium contenant du fluorure d'aluminium dans l'ordre à partir d'un côté du matériau de base,
la couche de fluorure d'aluminium est un empilement d'une première couche cristalline contenant du fluorure d'aluminium cristallin, d'une couche amorphe contenant du fluorure d'aluminium amorphe, et d'une seconde couche cristalline contenant du fluorure d'aluminium cristallin dans l'ordre à partir d'un côté de la couche de fluorure de magnésium,
la première couche cristalline et la seconde couche cristalline sont des couches dans lesquelles des points de diffraction sont observés dans une image de diffraction de faisceau d'électrons obtenue par irradiation d'un faisceau d'électrons, et
la couche amorphe est une couche dans laquelle un motif de halo est observé dans une image de diffraction de faisceau d'électrons obtenue par irradiation d'un faisceau d'électrons.

2. Élément résistant à la corrosion selon la revendication 1, dans lequel le matériau de base métallique est fait d'aluminium ou d'un alliage d'aluminium.

3. Élément résistant à la corrosion selon la revendication 1 ou 2, dans lequel une épaisseur de la couche de fluorure de magnésium est de 100 nm ou plus et de 1 000 nm ou moins.

4. Élément résistant à la corrosion selon l'une quelconque des revendications 1 à 3, dans lequel une épaisseur totale de la couche de fluorure d'aluminium est de 200 nm ou plus et de 50 000 nm ou moins.
